# EUROPEAN PATENT SPECIFICATION

(11) **EP 3 332 122 B1**
(45) Date of publication and mention of the grant of the patent: **03.06.2020**
(21) Application number: 16750625.2
(22) Date of filing: 08.08.2016
(51) Int. Cl.: F04C 2/18, F04C 18/18, G01B 11/26, G01B 7/30, G01D 5/12

(54) **DEVICE FOR PUMPING FLUID**
FLÜSSIGKEITSPUMPVORRICHTUNG
DISPOSITIF DE POMPAGE D'UN FLUIDE

(30) Priority: 07.08.2015 GB 201514032
(43) Date of publication of application: 13.06.2018
(73) Proprietor: Magpumps Limited, Bramshaw SO43 7JN (GB)
(72) Inventor: DEARDEN, Leo, Bramshaw SO43 7JN (GB)
(74) Representative: Norris, Timothy Sweyn
(86) International application number: PCT/EP2016/025084
(87) International publication number: WO 2017/025201

(56) References cited:
- EP-A1- 1 932 555
- WO-A1-2014/036419
- GB-A- 2 204 688
- GB-A- 2 490 115
- US-A1- 2014 169 987

## Description

### TECHNICAL FIELD

The present disclosure relates to devices, for example a gear pump, for pumping fluids. Moreover, the present disclosure concerns methods of using the aforesaid devices to pump fluids. Such fluids are, for example, liquids, gases, gels, emulsions, foam, powders, or any combination or mixture thereof.

### BACKGROUND

Gear pumps are used in a wide variety of technical fields, for example when manufacturing automobiles, in food industries, in medicine and so forth. Typically, a known gear pump includes two gear wheels (also referred as *"cogwheels*") that are operable to engage with each other, and are rotated when in operation in mutually opposite directions by a drive shaft of a motor. Moreover, the two gear wheels are arranged in a channel of a pump cylinder and are operable to create a suction pressure zone at an inlet of the channel and an ejection pressure zone at an outlet of the channel. Furthermore, the two gear wheels are constructed for allowing a positive displacement of a "substrate" for each cycle (i.e. rotation of the two gear wheels or the drive shaft) of pump operation; such a substrate is, for example a fluid, for example a liquid or a gas. A gear pump can attain a volumetric control in terms of discharge of the substrate therefrom by monitoring and controlling a rotational position of the drive shaft of the motor.

Contemporarily, for achieving such volumetric control, an optical encoder is used in conjunction with a gear pump. For example, the optical encoder is operatively coupled to a drive shaft of a motor of the gear pump for measuring a rotational position of the drive shaft, based upon which a specific volume of the substrate, for example a fluid, for example a liquid or gas, is discharged from the gear pump. Moreover, for the optical encoder to operate efficiently and accurately to measure the rotational position of the drive shaft, the optical encoder must be isolated or separated from the substrate, for example a fluid, for example a liquid or gas. Generally, for isolating the optical encoder from the substrate, for example fluid, for example liquid, a mechanical sealing arrangement is used such that the optical encoder is surrounded with air to function efficiently and accurately. However, the use of such a mechanical sealing arrangement increases an overall complexity and cost of manufacturing for such gear pumps. Moreover, gear pumps which do not incorporate such a sealing arrangement, or where the sealing arrangement is breached, cannot be used for pumping accurate volumes of the substrate, for example a fluid, for example a liquid or a gas, because the rotation of the drive shaft cannot be accurately measured in such a situation using the optical encoder. Therefore, it will be appreciated from the foregoing that known types of gear pumps, for example when pumping fluids, for example liquids or gases, suffer various problems that can adversely influencing their pumping accuracy.

In a published United Kingdom patent application GB 2, 204, 688A (Applicant: Danfoss AS) (published 1988), there is described a rotary machine with measuring means for measuring an angle of rotation. In such a rotary machine, a measuring means for measuring an angle of rotation comprises a series of marking element extending circumferentially of a carrier and a stationary signalling device with a sensing device associated with the series of marking elements. The carrier is formed by a rotary part of the machine. The sensing device is carried by a housing of the machine. The rotary machine is optionally a hydraulic motor or pump. The marking elements are optionally located on the end face or on the outer circumferential surface of the rotary part, and are optionally sensed using electric, magnetic or optical means.

In a published European patent application EP 1, 932, 555 A1, there is described an optical detection of medical pump rotor position, wherein the pump is of a peristaltic type. Rotation of a rotatable assembly of a medical pumping apparatus such as a pump rotor of a rotary peristaltic pump is monitored via use of electromagnetic radiation (for example, infrared radiation). The rotatable assembly is formed such that it has portions that are selectively reflective and non-reflective with respect to the electromagnetic radiation. An electromagnetic radiation emitter-detector pair is positioned such that as the rotatable assembly rotates, the reflective and non-reflective portions alternately pass through the electromagnetic radiation emitted by the emitter. The detector receives electromagnetic radiation reflected by the reflective portions, but the non-reflective portions absorb or disperse the electromagnetic radiation such that it is not received by the detector. An output circuit provides a signal indicating the position of the rotatable assembly as a function of the electromagnetic radiation received by the detector.

### SUMMARY

The present disclosure seeks to provide an improved device for pumping a fluid, for example a liquid or gas.

The present disclosure also seeks to provide an improved gear pump for pumping a fluid, for example a liquid or a gas, wherein gears of the improved pump are monitored and controlled in operation to sub-tooth angular resolution.

The present disclosure also seeks to provide an improved method of operating a gear pump for pumping fluid, for example a liquid or a gas.

According to a first aspect, there is provided a gear pump for pumping fluid, wherein the gear pump comprises:
- a motor for diving a rotatable drive shaft;
- a drive gear that is operable to be driven by the drive shaft;
- an idler gear which meshes with the drive gear;
characterized in that the gear pump further comprises:
- an annular magnet disposed coaxially with the drive shaft (108) and operable to rotate therewith;
- a sensor for sensing rotation of the annular magnet and generating an output signal corresponding to a rotational position of the drive shaft; and
- a controller that is operable to calculate the rotation position of the drive shaft based upon the output signal and to control the motor based upon the calculated rotational position to ensure that a controlled volume of fluid is pumped,
wherein the controller employs a PID control algorithm to cope with backlash, and
wherein, to avoid backlash, the idler gear is provided with viscous drag so that the idler gear always follows motion of the drive gear.

The present invention is capable of substantially eliminating the aforementioned problems in the prior art, and is capable of enabling pumping of a controlled volume of fluid, for example a liquid or gas, by a gear motor without being subjected to increased complexity and cost of manufacturing.

Optionally, in the gear pump, the sensor comprises a Hall Effect array that is operable to generate the output signal in a form of a Hall Effect voltage in response to the rotation of the annular magnet.

Optionally, in the gear pump, the annular magnet is disposed within the drive gear.

Optionally, in the gear pump, the annular magnet is magnetised diametrically.

Optionally, the gear pump includes a pump housing having an exterior surface.

More optionally, in the gear pump, the sensor is disposed on or proximal to the exterior surface of the pump housing.

More optionally, in the gear pump, the sensor is disposed on or proximal to an inside region within the exterior surface of the pump housing.

More optionally, in the gear pump, the exterior surface of the pump housing comprises a pump face.

More optionally, in the gear pump, the pump face comprises a trench and wherein the sensor is disposed at least partially within the trench.

More optionally, in the gear pump, the trench is positioned in the pump face such that the sensor is disposed coaxially with the annular magnet.

More optionally, in the gear pump, the pump face defines a fluid inlet port and a fluid outlet port.

According to a second aspect, there is provided a method of pumping fluid using a gear pump, characterized in that the method comprises steps of:
- driving a motor to rotate a drive shaft, and arranging for the drive shaft to rotate a drive gear and thereby an idler gear of a pump module for pumping fluid, and for rotating a sensor target associated with the drive shaft and/or the drive gear and/or the idler gear;
- using a sensor to sense rotation of sensor target and to generate an output signal corresponding to an angular position of the sensor target;
- calculating the rotation position of the drive shaft and/or the drive gear and/or the idler gear based upon the output signal; and
- controlling the motor based upon the calculated rotational position to controllably pump a volume of fluid,
wherein the controller employs a PID control algorithm to cope with backlash, and
wherein, to avoid backlash, the idler gear is provided with viscous drag so that the idler gear always follows motion of the drive gear.

Optionally, the method includes arranging for the sensor target to include an annular magnet.

Additional aspects, advantages, features and objects of the present disclosure would be made apparent from the drawings and the detailed description of the illustrative preferred embodiments construed in conjunction with the appended claims that follow.

### BRIEF DESCRIPTION OF THE DRAWINGS

The summary above, as well as the detailed description of the disclosure, is better understood when read in conjunction with the appended drawings. For the purpose of illustrating the present disclosure, exemplary constructions of the disclosure are shown in the drawings. However, the present disclosure is not limited to specific methods and instrumentalities disclosed herein. Moreover, those in the art will understand that the drawings are not to scale. Wherever possible, like elements have been indicated by identical numbers.

Embodiments of the present disclosure will now be described, by way of example only, with reference to the following diagrams wherein:
- FIG. 1: is a schematic view of a device for pumping fluid, in accordance with the present disclosure;
- FIG. 2 is: an exploded plan view of a gear pump, in accordance with the present disclosure;
- FIG. 3: is an exploded isometric view of the gear pump of FIG. 2, in accordance with the present disclosure;
- FIG. 4: is an assembled elevation view of the gear pump of FIG. 2, in accordance with the present disclosure;
- FIG. 5: is an assembled plan view of the gear pump of FIG. 2, in accordance with the present disclosure;
- FIGS. 6A-C: are the assembled plan view of the gear pump, a cross-sectional view of the assembled plan view about an axis A-A', and an enlarged view of a portion A" of the cross-sectional view, respectively, in accordance with the present disclosure;
- FIGS. 7A-C: are the assembled elevation view of the gear pump, a cross-sectional view of the assembled elevation view about an axis B-B', and an enlarged view of a portion B" of the cross-sectional view, respectively, in accordance with the present disclosure;
- FIGS. 8A-B: are the assembled elevation view of the gear pump and a cross- sectional view of the assembled elevation view about an axis C-C, respectively, in accordance with the present disclosure;
- FIGS. 9A-B: are the assembled elevation view of the gear pump and a cross-sectional view of the assembled elevation view about an axis D-D', respectively, in accordance with the present disclosure; and
- FIG. 10: illustrates a flow chart depicting steps of operation of the gear pump, in accordance with the present disclosure.

In the accompanying drawings, an underlined number is employed to represent an item over which the underlined number is positioned or an item to which the underlined number is adjacent. A non-underlined number relates to an item identified by a line linking the non-underlined number to the item. When a number is non-underlined and accompanied by an associated arrow, the non-underlined number is used to identify a general item at which the arrow is pointing.

The present disclosure will now be described in more detail by reference to preferred particular embodiments.

### DETAILED DESCRIPTION OF THE DISCLOSURE

Embodiments of the disclosure will now be described in more detail with reference to component parts of a device for pumping a fluid, for example a liquid. The embodiments concern a gear pump, and a method of operating such a gear pump.

According to an aspect, there is provided a device for pumping a fluid, wherein the device comprises:
- a motor for driving a rotatable drive shaft;
- a pump module to be driven in operation by the drive shaft; - a sensor target operatively associated with at least one of: the drive shaft, one or more rotatable pumping components of the pump module;
- a sensor for sensing a change in property of the sensor target as the drive shaft rotates in operation, and for generating an output signal corresponding to a rotational position of at least one of: the drive shaft, the one or more rotatable pumping components of the pump module; and
- a controller that is operable to calculate the rotational position of at least one of: the drive shaft, the one or more rotatable pumping components of the pump module, based upon the output signal and to control the motor based upon the calculated rotational position to ensure that a controlled volume of fluid is pumped.

Optionally, in operation of the device, the sensor is operable to measure an angular position of the drive shaft for generating the output signal, and the controller is operable to calculate the rotational position of the drive shaft for use in controlling the motor to ensure that a controlled volume of fluid is pumped.

Optionally, in operation of the device, the sensor is operable to measure an angular position of a driven rotating pumping component of the pump module for generating the output signal, and the controller is operable to calculate the calculated rotational position of the driven rotating pump component for use in controlling the motor to ensure that a controlled volume of fluid is pumped. Measuring the angular position of the driven component is capable of improving pump accuracy.

Optionally, in operation of the device, the sensor is operable to measure an angular position of an idling rotating pumping component of the pump module for generating the output signal, and the controller is operable to calculate the calculated rotational position of the idling rotating pumping component for use in controlling the motor to ensure that a controlled volume of fluid is pumped.

Optionally, in operation of the device, the sensor target comprises a disc that has alternate optically transparent and opaque patterns and a light source, and the sensor is a photodetector array that is operable to receive light from the optically transparent and opaque patterns to generate the output signal for use in controlling the motor to ensure that a controlled volume of fluid is pumped.

Optionally, in operation of the device, the sensor target comprises a material whose dielectric and/or conductive properties spatially varies, and the sensor includes a pair of electrodes that are operable to interact capacitively with the sensor target to generate an output signal in response to the rotation of the drive shaft causing a capacitance generated between the pair of electrodes to change.

Optionally, in operation of the device, the sensor target is fabricated from a material whose magnetic properties are spatially varying, and the sensor is operable such that its inductance changes as a function of angular position of the sensor target relative to the sensor, wherein the sensor is operable to generate the output signal in response to the rotation of the drive shaft.

More optionally, in operation of the device, the sensor target comprises a disc having circumferential teeth, and the sensor comprises a magnet and a surrounding coil assembly configured to generate the output signal in a form of magnetic flux as the change in the property in response to the rotation of the drive shaft.

Optionally, in operation of the device, the sensor target and the sensor are included within a pump housing of the device.

Optionally, in operation of the device, the sensor target and the sensor are exterior to a pump housing of the device.

Optionally, in operation of the device, the controller includes a plurality of servo loops coupled to the sensor for controlling the motor, wherein the plurality of servo loops are of mutually different response bandwidth and of mutually different gains.

More optionally, in operation of the device, at least one of the servo loops is operable to monitor an angular position of the drive shaft, and at least one of the servo loops is operable to monitor an angular position of at least one of the one or more rotatable pump components.

Optionally, in operation of the device, the device further comprises a pump housing, having an exterior surface, for accommodating the pump module therein.

More optionally, in the device, the sensor is disposed on or proximal to the exterior surface of the pump housing.

More optionally, in the device, the exterior surface of the pump housing comprises a pump face.

More optionally, in the device, the pump face defines a fluid inlet port and a fluid outlet port.

Optionally, in the device, the pump module is one of a rotary pump or a reciprocating pump.

Optionally, in device, the controller is operable to employ a nested position feedback loop.

According to another aspect, there is provided a gear pump for pumping fluid, wherein the gear pump comprises:
- a motor for diving a rotatable drive shaft;
- a drive gear that is operable to be driven by the drive shaft;
- an idler gear which meshes with the drive gear;
characterized in that the gear pump further comprises:
- an annular magnet disposed coaxially with the drive shaft and operable to rotate therewith;
- a sensor for sensing rotation of the annular magnet and generating an output signal corresponding to a rotational position of the drive shaft; and
- a controller that is operable to calculate the rotation position of the drive shaft based upon the output signal and to control the motor based upon the calculated rotational position to ensure that a controlled volume of fluid is pumped,
wherein the controller employs a PID control algorithm to cope with backlash, and
wherein, to avoid backlash, the idler gear is provided with viscous drag so that the idler gear always follows motion of the drive gear.

Optionally, in the gear pump, the sensor comprises a Hall Effect array that is operable to generate the output signal in a form of a Hall Effect voltage in response to the rotation of the annular magnet.

Optionally, in the gear pump, the annular magnet is disposed within the drive gear.

Optionally, in the gear pump, the annular magnet is magnetised diametrically.

Optionally, the gear pump includes a pump housing having an exterior surface.

More optionally, in the gear pump, the sensor is disposed on or proximal to the exterior surface of the pump housing.

More optionally, in the gear pump, the sensor is disposed on or proximal to an inside region within the exterior surface of the pump housing.

More optionally, in the gear pump, the exterior surface of the pump housing comprises a pump face.

More optionally, in the gear pump, the pump face comprises a trench and wherein the sensor is disposed at least partially within the trench.

More optionally, in the gear pump, the trench is positioned in the pump face such that the sensor is disposed coaxially with the annular magnet.

More optionally, in the gear pump, the pump face defines a fluid inlet port and a fluid outlet port.

According to another aspect, there is provided a method of pumping fluid using a gear pump, characterized in that the method comprises steps of:
- driving a motor to rotate a drive shaft, and arranging for the drive shaft to rotate a drive gear and thereby an idler gear of a pump module for pumping fluid, and for rotating a sensor target associated with the drive shaft and/or the drive gear and/or the idler gear;
- using a sensor to sense rotation of sensor target and to generate an output signal corresponding to an angular position of the sensor target;
- calculating the rotation position of the drive shaft and/or the drive gear and/or the idler gear based upon the output signal; and
- controlling the motor based upon the calculated rotational position to controllably pump a volume of fluid,
wherein the controller employs a PID control algorithm to cope with backlash, and
wherein, to avoid backlash, the idler gear is provided with viscous drag so that the idler gear always follows motion of the drive gear.

Optionally, the method includes arranging for the sensor target to include an annular magnet.

In respect of embodiments of the present disclosure, component parts of the embodiments will next be described in greater detail.

### Pump module

A pump module pursuant to the present disclosure includes a positive displacement pump, wherein the pump module is operable to pump a given volume of a substrate, for example a fluid, for example a liquid or a gas, in each cycle, or partial cycle, of its operation. Typically, the positive displacement pump functions by trapping a constant volume of substrate, for example a fluid, for example a liquid or gas, under conditions of constant pressure developed between a fluid inlet port to a fluid outlet port of the pump; the positive displacement pump is thus operable to pull in, for example by viscous drag, the constant volume of substrate, for example fluid, for example liquid or gas, through the fluid inlet port of the pump and pushing out, namely pumping or dispensing, that constant volume of substrate, for example fluid, for example liquid or gas, through the fluid outlet port of the pump; however, it will be appreciated that, in a practical embodiment, the pressure developed between a fluid inlet port to a fluid outlet port of the pump will often vary as a function of time. The pump module optionally includes an expanding cavity near the fluid inlet port to pull the substrate, for example fluid, for example liquid or gas, into the pump and a decreasing cavity near the fluid outlet port, so as the decreasing cavity collapses, namely momentarily reduces in size in operation, the substrate, for example a fluid, for example a liquid or gas, is pumped out via the fluid outlet port. The positive displacement pump is implemented as a rotary type of pump or a reciprocating type of pump.

### Rotary pump

A rotary pump displaces a constant volume of substrate for each revolution, or partial revolution of a drive shaft of the rotary pump. A rotary pump optionally includes pump modules such as gears, screws, vanes and so forth. Accordingly, the rotary pump is optionally a gear pump, a screw pump, a vane pump, and so forth.

### Gear Pump

A gear pump includes components such as a motor and a gear arrangement for pumping or dispensing a substrate, for example a fluid, for example a liquid or gas, therethrough. Moreover, the gear pump is operable to provide a consistent output for a certain pressure range, namely pressure difference developed in operation between an inlet port and an outlet port of the gear pump, and an operating speed of the gear arrangement of the pump. It is assumed, for the gear pump, that there is employed precise and close fittings and connections between the gear arrangement and a housing of the pump. The gear pump optionally, further includes an external gear arrangement or an internal gear arrangement. In an example embodiment of the present disclosure, the gear pump is further provided with a control arrangement for providing volumetric control of fluid that is pumped in operation through the gear pump; namely, the gear pump is operable to pump a controlled volume of fluid by way of using a measurement of a rotational position of a drive shaft of the gear pump. A desired rotational position of the drive shaft is monitored and controlled by providing a required amount of electrical power to the motor; obtaining such a desired rotational position will be explained in greater detail below.

### Screw pump

A screw pump is implemented as a single screw pump or as a multiple screw pump; the multiple screw pump includes two or more screws. A substrate, for example a fluid, for example a liquid or gas, is carried by threads of a given single screw that is rotated in operation by using a motor along a stationary element such as a cylindrical cavity, in a case of a single screw pump. A multiple screw pump, namely including two or more screws, includes a rotating drive screw and one or more idler screws. In operation, a rotation of the screws of the multiple screw pump pulls the substrate, for example a fluid, for example a liquid or gas, from a fluid inlet port, wherein the substrate is carried in cavities formed by the screw threads and further pumped through a fluid outlet port.

### Reciprocating pump

A reciprocating pump is implemented in operation as an oscillating pump module including one or more pistons, plungers or diaphragms and valves to restrict the flow of a substrate, for example a fluid, for example a liquid or gas, in a desired flow direction. A piston pump includes a piston, a chamber and valves at an inlet port of the piston pump, and at an outlet port of the piston pump. A reciprocating motion of the piston is optionally provided through a crank connected to a motor and a shaft coupling the crank with the piston. A diaphragm pump is optionally implemented to include a flexible diaphragm that reciprocates in operation between two positions, and to include valves at both sides of the diaphragm. In operation, a substrate, for example a fluid, for example a liquid or gas, is pulled into the pump using suction created at an inlet port when the diaphragm moves up, and as the diaphragm moves down, the substrate is pumped out.

### Substrate

A "substrate" with respect to a gear pump refers to any substance that can be pumped or dispensed by the gear pump, for example an emulsion, a powder, a liquid, a gas, a foam, a gel, and so forth. Moreover, the substrate is optionally referred to as being a feedstock, and accordingly is interchangeably used when describing embodiments of the present disclosure. In an example, the substrate includes a liquid or gel that is able to flow. It will be appreciated that the gear pump is capable of being used in multiple technical fields, such as medicine research and production, food processing and production, chemical industries, oil and gas industries, water treatment industries, in power generation industries, in fuel delivery systems and so forth For example, the substrate is anything that is compatible with components of a gear pump and that is not too viscous to be pumped including, without limitation, an oil, a chemical, a cosmetic product such as a perfume or a lotion, medicines, veterinary products, liquid foods or sauces, glues, paints and other such products.

### Volumetric control

Volumetric control refers to controlling an amount of the fluid to be pumped by a gear pump. Typically, gear pumps include gears having regular teeth and spaces between them; the gears are closely fitted inside a channel of a pump cylinder, wherein the gears provide a uniform volume formed by spaces between each of the gear teeth and the pump cylinder. Therefore, the gear pump is optionally used in processes wherein volumetric control is required, requiring that exact rotations, or exact fraction of a rotation, of a drive shaft of the gear pump be measured and controlled.

### Motor

In one embodiment of the present disclosure, a motor is driven, and its shaft is monitored to determine its angular position and correspondingly speed control. For example, asynchronous motors or synchronous motors are employed to drive the shaft. In an embodiment, an asynchronous motor, such as a brush DC motor, an AC induction motor, and so forth, is operated with position and speed control being utilized. Specifically, a suitable servo drive, a position sensor, and/or a speed sensor is used to control the asynchronous motor. In another embodiment, a synchronous motor is operated by employing position and speed control in an open-loop configuration, namely without position or speed feedback. Such a synchronous motor is implemented, for example, as a stepper motor. Therefore, in such embodiment, a low pole count synchronous motor may be replaced by a stepper motor. Optionally, an open loop stepper drive is used, and a rotary encoder is omitted.

In an example embodiment, the motor is a servomotor that is operable to function based upon a positional feedback voltage signal provided in operation from an encoder, that allows a controller to modulate a motor drive voltage, or applied electrical power, so as to control very precisely a speed and/or position of a shaft if the motor; by "very precisely" is meant, for example, to an angular resolution that is less than a tooth angle of a gear employed in a gear pump, for example to an angular resolution in a range of a gear tooth angle to 10% of a gear tooth angle. Moreover, the motor is optionally a brushless three phase motor, for example a three-phase motor that is designed to provide a considerable amount of torque over a large rotational speed range. The motor primarily operates or converts electrical signals provided from a power source into mechanical energy for moving or driving a mechanical component, particularly a drive shaft of the motor. The motor includes various components, which are explained in greater detail below.

### Motor casing

A motor casing is an outer protective covering of a motor that is arranged, namely configured, to house internal components of the motor, such as a motor stator and a motor rotor. In an embodiment, the motor casing is arranged, namely configured, to be a hollow cylindrical structure; however, the motor casing optionally has any other shape that is utilized for convenient housing of the internal components. The motor casing is optionally made of an insulating material, such as a plastics material, with a metallic base. Alternatively, the motor casing is made of an alloy such as steel, or cast Aluminium. Furthermore, the motor casing is optionally made by utilizing a suitable manufacturing technique such as press-forming, injection moulding and the like. The motor casing is operable, namely adapted, to support rigidly the motor stator and the motor rotor therein. The motor casing also includes a few small holes for allowing motor power wiring, to pass therethrough, which allows electric energy to flow to different parts of the motor.

### Motor stator

A motor stator is a stationary part of a motor that is supported and covered by a motor housing. For example, the motor stator is arranged, namely configured, to have a cylindrical shape, wherein the cylindrical shape has a smaller diameter compared to the motor casing, such that the motor stator is housed within the motor casing. In an example embodiment, the motor stator is an electromagnet, including windings supported over a cylindrical frame. The windings are optionally manufactured from copper; otherwise, the winding is manufactured from a material having a higher electrical conductivity compared to copper. Furthermore, the motor stator optionally includes metallic and/or alloy laminations to reduce energy losses.

### Motor rotor

A motor rotor constitutes a rotating part of a motor. The motor rotor is manufactured to have a cylindrical shape with a smaller diameter compared to a corresponding motor stator, such that the motor rotor can be covered by the motor stator. In an embodiment, the motor rotor is a permanent magnet; otherwise the motor rotor is an electromagnet. For example, the motor rotor has windings manufactured from a highly electrically conductive metal or from specific alloys, such as steel.

The motor rotor rotates in operation generally under an influence of a magnetic field. In operation, the motor rotor operates through an interaction between its own magnetic field and a magnetic field, namely opposite in nature, produced by winding currents of a motor stator.

### Drive shaft

A motor includes a drive shaft for providing a mechanical output in response to receiving an electrical input. Typically, the drive shaft is an elongate cylindrical element supported at one end of a motor casing and at another end on a pump head casing. In an embodiment, both ends of the drive shaft are supported with bearings for having minimum friction when rotating in operation. Furthermore, the drive shaft is also arranged, namely configured, to rotate under an influence of a magnetic field. Specifically, a motor rotor is mounted on a drive shaft, therefore with a rotation, or partial rotation of the motor rotor, the drive shaft is operable to rotate. In an example embodiment, the motor rotor is mounted rigidly onto the drive shaft, for example the motor rotor and the drive shaft are a unitary component.

### Front bearing and rear Bearing

A front bearing and a rear bearing are employed to reduce, for example to minimize, friction and allow easy rotation of a drive shaft therebetween. Both the front bearing and the rear bearing are coaxially attached on end portions of the rotatable drive shaft, particularly with the front bearing being received in a through opening provided in the pump head casing, and the rear bearing being received in a cut-out provided in the motor casing. In an example embodiment, the front and rear bearings are sleeve bearing, ball bearings or roller bearings.

Typically, components of an example gear pump are arranged in a following order: bearing -> motor -> bearing -> pump. In other embodiments, this configuration is optionally varied depending on expected loads and volumes of a fluid, for example a liquid or gas, to be pumped by attaching a further bearing after the pump or by placing the second bearing after the pump, giving either a bearing -> motor -> bearing -> pump -> bearing configuration or a bearing -> motor -> pump -> bearing configuration. Furthermore, the bearings are optionally a single row deep groove bearing arrangement, a double row angular contact bearing arrangement and the like. Furthermore, the bearings are optionally a single row deep groove bearing arrangement, a double row angular contact bearing arrangement and the like.

### Drive gear and Idler gear

Typically, a gear pump includes two gears, namely a drive gear and an idler gear; these two gears are optionally fabricated from a metal, from a plastics material (for example "peek" (polyaryletherketone) or nylon (polyamide)), from a ceramics material, from an amorphous material (for example a glassy material) or other strong materials. In an example embodiment, both the drive and idler gears include an involute gear profile. Thus, in an involute gear profile, the drive gear and the idler gear form a gear train having a gear ratio equal to 1. Specifically, both the drive and idler gears are of equal diameter, and include an equal number of teeth on the gears. Alternatively, the drive gear and the idler gear form a gear train having a gear ratio that is more than 1, or is less than 1 (namely non-involute). Furthermore, the drive gear is optionally operable, namely adapted, to be mounted onto a part of a drive shaft that protrudes beyond a front bearing, whereas the idler gear is operable, namely adapted, to engage with the drive gear for providing a pumping function. Optionally, to avoid backlash, the idler gear is provided with viscous drag (for example via electromagnetic induction drag when the idler gear is fabricated from a conductive material and rotates within a strong magnetic field (for example in a range of 0.1 to 1 Tesla) and thus the drive gear is always angularly advanced relative to the idler gear.

In an example embodiment, the drive gear is mounted over an annular magnet, coupled to the drive shaft, which is explained in greater detail below. Specifically, the drive gear conforms to an external surface of the annular magnet (namely surrounds the annular magnet) and is detachably or permanently fixed to the annular magnet using a suitable coupling arrangement, such as a key-and-slot arrangement, or by using an adhesive. Furthermore, the drive gear and the idler gear are arranged, namely adapted, to be received in a channel of a pump cylinder, namely as explained in greater detail below.

In operation, the drive gear is rotated by the drive shaft of the motor, and the idler gear is rotated by the drive gear. The drive gear and the idler gear rotate in mutually opposite rotation directions, and pull the substrate, for example a fluid, for example a liquid or gas, into the channel and thereafter push the substrate out from the channel, namely pump the substrate from the channel. For example, with the rotation of the drive shaft, the drive gear rotates in an anti-clockwise direction and the idler gear rotates in a clockwise direction, and teeth of the drive and idler gears mutually mesh in a middle region of the channel, and are operable to pull the substrate into the channel and thereafter push the substrate out from the channel . As aforementioned, the idler gear optionally has viscous drag applied thereto to avoid backlash arising in the drive and idler gears. Such backlash is otherwise potentially susceptible of causing one of more servo loops, for example a plurality of nested servo loops, of the controller to function in an unstable manner.

### Pump head casing:

The pump head casing is arranged, namely configured, to have a cylindrical shape, otherwise it is arranged to have another shape such as a cuboidal shape. Furthermore, the pump head casing is optionally manufactured from a suitable material such as a plastics material, rubber, a metal or any combination thereof; there is beneficially employed a suitable manufacturing method such as injection moulding, compression moulding and thermoforming, but not limited thereto.

The pump head casing includes a circular cut-out that provides a hollow construction to the pump head casing. Specifically, the circular cut-out is big enough so that the pump head casing is hollow. Alternatively, the pump head casing includes a cut-out of other shapes, such as a rectangular shape or an oval shape, so that the pump head casing is hollow. The pump head casing also includes a through opening arranged, namely configured, centrally thereon. The through opening conforms to an external surface of the rear bearing, namely arranged, namely adapted, to be mounted on the drive shaft of the motor. Specifically, the through opening of the pump head casing is arranged, namely adapted, to accommodate the rear bearing and provide a frictionless movement between the pump head casing and the drive shaft of the motor.

### Pump cylinder

The pump cylinder includes a cylindrical shape essentially conforming to the circular cut-out shape of the pump head casing. Alternatively, the pump cylinder is arranged, namely configured, to have other shapes, such as a rectangular shape or an oval shape, but essentially conforming to the cut-out shape of the pump head casing, such that the pump cylinder is accommodated in the cut-out of the pump head casing. The pump cylinder is also made of a suitable material such as a plastics material, rubber, a metal or any combination thereof, and using a suitable manufacturing method such as injection moulding, compression moulding and thermoforming.

The pump cylinder includes a channel (namely a through opening) conforming to external surfaces of the drive gear and the idler gear. Specifically, the channel conforms to the external surfaces of the drive gear and the idler gear, when the drive gear and the idler gear are in a meshed or mutually engaged arrangement. The channel of the pump cylinder is therefore capable of accommodating the drive gear and the idler gear when the drive gear and the idler gear are mutually meshed, and allows rotation the drive gear and the idler gear therein. The channel is also arranged, namely configured, to have side openings (on either sides of the channel), and in line with the fluid inlet port and fluid outlet port of the pump. Furthermore, the rotation of the drive gear and the idler gear within the channel of the pump cylinder is operable to create a suction pressure zone at a side opening, namely on the fluid inlet port side, and an ejection pressure zone at another side opening, namely on the fluid outlet port side. Moreover, the drive gear and the idler gear are arranged to provide uniform and defined gaps therebetween, for allowing a small but uniform amount of substrate, for example a fluid, to displace from the side opening, on the fluid inlet port side, to the side opening, on the fluid outlet port side, of the channel of the pump cylinder.

### Pump face

The pump face is also arranged, namely configured, to have a cylindrical shape to conform to the cylindrical shape of the pump head casing. Alternatively, the pump face is arranged, namely configured, to have other shapes, such as a cuboidal shape, but essentially is capable of being coupled to the pump head casing. The pump face is coupled to the pump head casing, using a suitable coupling arrangement such as bolts or clamps. The pump face is optionally made of a suitable material such as a plastics material, rubber, a metal or any combination thereof, and using a suitable manufacturing method such as injection moulding, compression moulding and thermoforming.

The pump face of the gear pump constitutes an exterior surface of the pump housing. Specifically, the pump face acts as a front face of the gear pump and accommodates the fluid inlet port and the fluid outlet port for the substrate. The fluid inlet and outlet ports are circular through-holes arranged on the pump face. Furthermore, the fluid inlet and outlet ports are optionally disposed in a mutually similar plane. Optionally, the fluid inlet and outlet ports are either parallel to each other, or perpendicular to each other. Alternatively, the fluid inlet and outlet ports are optionally adjacent to each other or placed in any other position relative to each other on the pump face for allowing their intended function of permitting the substrate, for example a fluid, for example a liquid or gas, to flow into and from the pump. In operation, the fluid inlet and outlet ports are provided with pipes or conduits, for example made of a metal or a plastics material, permitting the substrate to flow into and from the pump.

In an example embodiment, the pump face also includes a trench, namely not a through opening, namely extending from an outer surface to an inner surface of the pump face. The trench is optionally a rectangular cut-out, otherwise it is arranged, namely configured, to have a circular shape. Furthermore, the trench is centrally configured on the pump face and disposed between the fluid inlet and outlet ports of the pump face so as to be in an optimal proximity, for example, to the annular magnet embedded in the driven gear which is immediately behind the pump face.

### Sensor target

A sensor target is operatively coupled with the drive shaft; alternatively, or additionally, the sensor target is included as an integral part of gears of a gear pump, for example. For example, the sensor target is mounted on the drive shaft and has a property (such as electrical, optical, magnetic, capacitance associated therewith). Therefore, as the motor shaft rotates, the sensor target rotates, to cause a change in the property of the sensor target. The sensor that is positioned in the proximity of the sensor target detects the change in the property and produces an output signal which further corresponds to the rotational position of the sensor target, and therefrom vicariously the rotational position of the drive shaft.

### Annular magnet

In an example embodiment, magnetic sensing of the angular position of the drive shaft is employed. For such magnetic sensing, the sensor target includes an annular magnet; the annular magnet is optionally a permanent magnet made from a material that is magnetized and creates its own persistent magnetic field. The annular magnet is arranged, namely configured, to have a cylindrical shape with a cylindrical hole along its central axis. Optionally, the annular magnet is of a larger diameter compared to a width of the annular magnet. Alternatively, the annular magnet is optionally arranged to be of smaller or same diameter compared to the width of the annular magnet.

The annular magnet is arranged, namely adapted, to be placed around, and fixed coaxially, with the drive shaft of the motor. For example, the cylindrical hole of the annular magnet is large enough to conform to a diameter of the drive shaft, and is detachably or permanently fixed to the drive shaft using a suitable coupling arrangement, such as a key and slot arrangement or by using an adhesive. Furthermore, the annular magnet is optionally surrounded by the drive gear, particularly, the drive gear including a circular hole that is large enough to conform to an external diametrical surface of the annular magnet to surround the annular magnet.

Furthermore, the annular magnet is optionally magnetised diametrically, rather than axially, for optimum signal generation or induction. In operation, the annular magnet is arranged, namely adapted, to be rotated with the rotation of the drive shaft to generate Hall Effect signals or voltage signals. Specifically, rotation of the annular magnet causes oscillation of an associated magnetic field around the annular magnet. For example, the oscillation of the magnetic field associated with the annular magnet results in electrical cycles of sine and cosine voltage signals, based on the number of magnetic pole pairs ("South" and "North" poles) in the annular magnet.

### Sensor

The sensor is optionally a magnetic sensor, such as a Hall Effect array. However, for sensor targets other than magnetic targets, there is optionally employed an electrostatic sensor (namely, a variable capacitance sensor), an inductive sensor, a mechanical sensor and so forth. The sensor, whatever type is utilized, is disposed on or proximal to the exterior surface of the pump housing. In an example, the exterior surface of the pump housing includes a pump face and the pump face includes a trench, wherein the sensor is disposed at least partially within the trench. Specifically, the trench is configured on the pump face such that a distance between the sensor and the sensor target is reduced and the sensor can easily and efficiently sense or measure the rotation of the sensor target. Moreover, the trench is positioned, namely configured, in the pump face, such that the sensor is disposed coaxially with the sensor target, namely symmetrically with respect to a central axis of the annular ring, when a magnetic sensor is employed. Alternatively, the trench is optionally arranged, namely configured, on the pump face asymmetrically with respect to the central axis of the annular ring, when a magnetic sensor is employed, and the sensor is optionally positioned non- coaxially with respect to the sensor target. Furthermore, the sensor may be coupled to the trench using a suitable coupling arrangement such as glue or mechanical clamps.

The position of the sensor on the trench of the pump face isolates the sensors from the substrate, namely from a fluid, for example a liquid or gas. Specifically, the substrate enters into and exits from the channel through the fluid inlet and outlet ports provided in the pump face. Therefore, there is no possibility, in such an implementation, of any interaction between the sensor and the substrate, with the pump face between the channel and the sensor.

In operation, when a magnetic sensor is employed, the magnetic sensor is operable, namely adapted, to sense the rotation of the annular magnet and generate an output signal corresponding to a rotational position of the drive shaft. The magnetic sensor is operable, namely configured, to generate the output signal in the form of a Hall Effect voltage in response to the rotation of the annular magnet. Specifically, when the annular magnet is rotated, the oscillation of the magnetic field associated with the annular magnet generates a voltage signal or the Hall Effect voltage, which are sensed by the sensor. Furthermore, such Hall Effect voltage corresponds to the rotational position of the drive shaft, since the Hall Effect voltage changes with a portion of a rotation, or a number of rotations, namely an angular position, of the annular magnet. Specifically, for different number of rotations, or angular positions, of the annular magnet, the drive shaft attains different rotational positions and generates different Hall Effect voltage. For example, if the annular magnet rotates one complete cycle (or 360 degrees), the sensor generates an output signal (or a Hall Effect voltage of between 3.3 and 5 volts) corresponding to the oscillation of the magnetic field associated with one complete rotation of the annular magnet. Furthermore, the output signal generated by the sensor corresponds to the rotational position of the drive shaft, for example to an accuracy and/or a resolution error of less than 1 degree, more optionally to an accuracy and/or resolution error of less than 0.25 degrees, and yet more optionally to an accuracy and/or resolution error of less than 0.1 degrees, since the annular magnet is mounted on the drive shaft and associated with the angular displacement of the annular magnet. It will be appreciated that such high accuracies pertain also to other types of sensors as described herein, for example non-magnetic types of sensors. Therefore, the sensor generates different output signals (or Hall Effect voltage) corresponding to different number of rotations (such as 2, 3...n rotations) or angular positions (such as 30, 45, ....90°) of the annular magnet.

### Optical sensor

In an example embodiment of the present disclosure, there is employed an optical sensor optionally including a photodetector array. In an example embodiment, the sensor target has alternate transparent and opaque patterns such as lines, and is optionally coupled to the drive shaft and placed in the path of a light source. As the drive shaft rotates, the light source is alternatively blocked and unblocked (namely interrupted) which is sensed by the photodetector array. The alternating light beam sensed by the photodetector array is converted into an optical potential (such as an electrical signal or voltage). The optical potential is further sent to be analysed, for example in a data processing arrangement in including computing hardware that is operable to execute one or more software products including program instructions, to determine the rotational speed of the drive shaft. Additionally, the pump face is optionally made of an optically transparent material for the photodetector array to sense the light beam passing through the sensor target; the optically transparent material is, for example, a glass, a plastics material such as polycarbonate plastics material or similar. However, it will be appreciated that such an optical sensor employs a light source such as a solid state laser, a light emitting diode, a nanowire plasmon resonance light source, an organic light emitting diode and so forth. Optionally, light for the optical sensor is conveyed via an optical fibre, for example via a port on a house of the gear pump. Optionally, the optical sensor is remote from the gear pump housing and optically couple via an optical fibre. Such an arrangement is of benefit because optical-fibre-based sensors are very immune to electromagnetic interference and is potentially also robust against ionizing radiation.

### Electrostatic sensor

An electrostatic sensor, namely a variable capacitance sensor, is beneficially employed for measuring the rotational speed of at least one of: the drive shaft, the drive gear, the idler gear, for example on both the drive shaft and also the drive gear or idler gear, for example in ultra-precise pumping situation wherein any backlash in the gear pump has to be compensated by the controller. Such an electrostatic sensor optionally includes a pair of electrodes defining a spatial region therebetween. Changes in dielectric permittivity and/or conductivity within the spatial region is capable of resulting in corresponding changes in capacitance that is sensed between the pair of electrodes for generating an output signal for processing by the controller.

The change is capacitance is susceptible to being detected in several different ways. For example, a capacitance provided between the pair of electrodes can be used to define an operating frequency of an oscillator, for example an LC resonant oscillator, wherein changes in frequency of the oscillator are indicative of changes within the spatial region; a phase-lock-loop can be used, for example, to measure the frequency . Alternatively, the capacitance provided between the pair of electrodes can be employed as part of a capacitive potential divider or a Wheatstone bridge that is provided with an a.c. excitation signal.

Optionally, the pair of electrodes is included in the pump face and shielded from the substrate by a thin dielectric layer; moreover, the gears of a gear pump, to be sensed by such an electrostatic sensor are provided with conductive or dielectric features, for example accommodated recesses or inserts, or deposited onto the gears, for example arranged in a radial manner, that vary as a function of a rotational position of the gears; such features correspond to the aforementioned "sensor target". Optionally, the pair of electrodes is conveniently arranged such that each electrode is elongate and disposed in a radial manner also. By such an approach, elongate radially- disposed electrodes used to detect elongate radially-disposed conductors or dielectric features can provide a high degree of angular resolution when detecting angular position of gears of a gear pump.

Thus, a dielectric layer disposed between the pair of electrodes is arranged so that its thickness and/or relative permittivity changes as a function of rotation of the dielectric layer, wherein the dielectric layer is mounted to a shaft or gear. As a result, in operation, a capacitance provided between the two electrodes varies as a function of rotation of the dielectric layer. In an example embodiment, the capacitance is employed to define an operating frequency of an oscillator, as aforementioned wherein the operating frequency is measured for determining an angular position of the dielectric layer. In another embodiment, the capacitance is employed in an a.c. Wheatstone bridge circuit arrangement or an a .c. potential divider circuit arrangement for providing an a .c. signal output whose amplitude is a function of an angular position of the dielectric layer. In such a Wheatstone bridge circuit arrangement or a.c. potential divider, an a.c. excitation signal for the Wheatstone bridge or a.c. potential divider circuit, and synchronous detection of a difference signal from the Wheatstone bridge circuit arrangement or from the a.c. potential divider circuit is employed, to reduce effects of asynchronous external interfering signals. Such an electrostatic sensor is especially beneficial when very high accuracy of operation is required for the gear pump when its gears revolve at extremely high speeds, where induced eddy-currents associated with magnetic sensors would result in measurement inaccuracies. The electrostatic sensor is capable of providing in operation, for example, an angular position measurement to an accuracy and/or a resolution error of less than 1 degree, more optionally to an accuracy and/or resolution error of less than 0.25 degrees, and yet more optionally to an accuracy and/or resolution error of less than 0.1 degrees.

### Inductive sensor

An inductive sensor is operable to exhibit a change in inductance as conductive materials or magnetic materials are brought in close spatial proximity of the inductive sensor. For example, the inductive sensor is implemented as a coil, and a gear of a gear pump is fabricated from a plastics material, for example "peek" or ceramic as aforementioned, wherein recesses are formed into the peek or ceramic for accommodating ferromagnetic or conductive inserts, for example elongate inserts that are disposed radially in the gear.

In another embodiment, the pump face is fabricated from a plastic material and the inductive sensor is implemented as a coil, namely an electrical winding. Optionally, a magnetic core, for example fabricated from a ferrite material or magnetic laminate material, is included at a centre of the coil. When a given gear of a gear pump is fabricated from a ferromagnetic material, for example from a magnetic steel allow, surface indents and striations on the gear can be sensed using the inductive sensor. In an example embodiment, the sensor target is a disc (or ring) with teeth positioned in front of the inductive sensor such that the magnetic field of a permanent magnet included in the inductive sensor extends to the disc. The disc is further coupled to the drive shaft. As the shaft rotates, the disc is also rotated. A tooth of the disc that is in front of the inductive sensor concentrates the magnetic field and further, amplifies the magnetic flux in the coil whereas the space between the teeth in front of the sensor reduces the magnetic flux in the coil. The changes in the magnetic flux induce an a .c. voltage in the coil which can be analysed to determine the rotational speed of the shaft.

### Controller

The controller is operatively coupled to the sensor for receiving the output signal, for example a Hall Effect voltage, of the sensor. The controller includes a plurality of electronic components, such a microcontroller, a power source (or a battery), a data memory and a wired link, or a wireless link including an antenna and the like, for establishing a communication with the sensor for receiving the output signal. The controller is this, optionally, wirelessly coupled or coupled with a wire to the sensor. In an embodiment, the controller is a servo-controller (namely, a controller of the motor). Alternatively, the controller is operatively coupled to the sensor to form a unitary electronic unit, which is spatially separate from the servo-controller. Conveniently, a micropower microcontroller is employed when constructing the controller, alternatively a low-power risk processor.

The controller is operable, namely configured, to calculate the rotational position of the drive shaft based upon the output signal of the sensor; for such calculation, there can be used look-up tables, polynomial models, or artificial intelligence (Al) learned computations. Specifically, the controller is operable to identify a relationship between the sensor signal, for example the Hall Effect voltage or the output signal (namely a strength of a magnetic field caused by the rotation of the annular magnet) generated by the sensor, and the rotational position of the drive shaft. It will be appreciated that the controller (particularly the microcontroller) is optionally operable to execute an algorithm for associating the measurement data from the sensors (for example, a normalized Hall Effect voltage) with the rotational position of the drive shaft. Furthermore, there is optionally a linear relationship between the rotational position of the drive shaft and the output signal of the sensor, and the output signal of the sensor is optionally an absolute value corresponding to the rotational position of the drive shaft; alternatively, there is optionally a polynomial relationship between the rotational position of the drive shaft and the output signal of the sensor, wherein the algorithm is arranged to take into account such a polynomial relationship, for example by way of employing spline coefficients. For example, the controller is operable to calculate (or correlate) the rotational position of the drive shaft to be 30°, 90°, 360°, 720° and the like based on the multiple output signal of the sensor. However, it will be appreciated that embodiments of the present disclosure are capable of being implemented to a have an angular measurement resolution and/or accuracy error of less than 1 degree, more optionally, less than 0.25 degrees.

The controller is also operable, namely configured, to control the motor based upon the calculated rotational position to ensure that an accurate volume of fluid is pumped. Specifically, the controller is operatively coupled to an electrical power source of the motor, such that based on a control command from the controller a pre-determined amount of electrical power is provided to the motor from the electrical power source. Therefore, the drive shaft of the motor is operable, namely configured, to have a pre-determined amount of rotation based on the pre-determined amount of electrical power. This causes a pre-determined volume of fluid to be pumped or dispensed by the motor based on the pre-determined amount of rotation of the drive shaft thereof. Beneficially, in such control, account is taken of a pressure developed across the pump, from its inlet port to its outlet port, and a correction applied when the pressure changes in operation, to ensure that a controlled quantity of fluid is pumped through the gear pump. Such a pressure difference is conveniently measured in operation by using a Silicon micromachined pressure sensor, a bellows-type pressure sensor or similar.

Accordingly, by controlling the rotational position of the drive shaft, pumping of the accurate volume of fluid by the gear pump can be attained. For example, if the gear pump is provided (or instructed) with a command for dispensing (or pumping) one litre of fluid, in such instance the controller monitors the angular position of the drive shaft based upon the output signal of the sensor. Thereafter, the controller compares the monitored angular position of the drive shaft with a pre-determined angular position of the drive shaft (corresponding to the one litre of fluid) with which the controller is trained. Specifically, the controller is optionally trained with measurement data associated with the rotational position of the drive shaft based on the output signal generated by the sensor corresponding to such rotational position of the drive shaft. The rotational position of the drive shaft corresponds to (namely is associated with) a pumping or dispensing capacity of the gear pump is susceptible to being computed; therefore, the amount of electrical power provided to the gear pump corresponds to the pumping or dispensing capacity of the gear pump.

Therefore, in an example embodiment, the controller computes, namely detects, any difference between the monitored angular position and the pre-determined angular position of the drive shaft; the controller corrects or regulates the electrical power to the motor. The correction of electrical power to the motor causes the drive shaft to attain the pre-determined angular position from the monitored angular position. This allows the gear pump to dispense or pump an accurate volume, such as one litre, of fluid by the gear pump. However, it will be appreciated that embodiments of the present disclosure are capable of being implemented to a have an angular measurement resolution and/or accuracy error of less than 1 degree, more optionally, less than 0.25 degrees.

In an example embodiment, data from the servo-controller, such as speed, torque, position, and so forth, are cross-referenced with sensor data for achieving an enhanced accuracy, a process control, and for monitoring overall system health of the gear pump and its associated parts. In an example embodiment, adding a differential pressure sensor across the gear pump is beneficial in that it allows distinguishing between changes in mechanical losses in the pump (for example, due to wearing out of the pump rotor) and viscous losses in the substrate (for example, due to increased suspended particle loads or polymer chain lengths). Furthermore, in such an example embodiment, a closed loop control of pressure is possible and accuracy of volumetric control is enhanced by modelling and compensating for variations in volume transport with varying pressure. In another example embodiment, adding a flow meter in line with the gear pump optionally enhances failure detection by cross checking expected and measured behaviour at the pump and the flow meter. In such an example embodiment, an accuracy of volumetric control is enhanced by adding an outer servo loop which senses flow at the flow meter and actuates the pump position. In yet another example embodiment, the differential pressure sensor is optionally added across and the flow meter and is optionally added in line with the pump. In such an example embodiment, a viscosity of the substrate is inferred from torque, pressure, and flow rate measurements made on the gear pump. Furthermore, an accuracy of detection of wear in the pump head, as shown by internal leakage, is optionally increased by measuring a pressure-to-volume-ratio-per-revolution of the drive shaft, while modelling the expected value from the inferred viscosity.

### DESCRIPTION OF PREFERRED EMBODIMENTS

The following detailed description illustrates preferred embodiments of the present disclosure and ways in which they can be implemented. Although some modes of carrying out the present disclosure have been disclosed, those skilled in the art would recognize that other embodiments for carrying out or practicing the present disclosure are also possible.

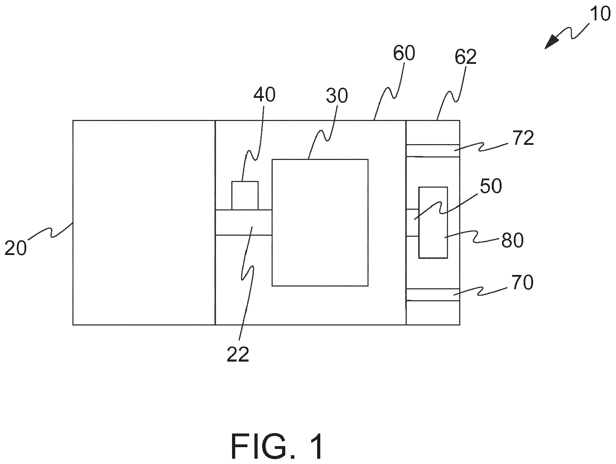

In FIG. 1, there is provided a schematic view of a device **10** for pumping fluid, in accordance with the present disclosure. The device **10** includes a motor **20** for driving a rotatable drive shaft **22.** The device **10** also includes a pump module **30** to be driven by the drive shaft **22.** The device **10** further includes a sensor target **40** that is operatively associated with the drive shaft **22.** The device **10** also includes a sensor **50** for sensing a change in a property of the sensor target **40** with the rotation of the drive shaft **22,** and for generating an output signal corresponding to a rotational position of the drive shaft **22;** the sensor **50** is beneficially implemented magnetically, inductively, electrostatically (variable capacitance), for example as described in the foregoing. The device **10** further includes a pump housing **60** to accommodate the pump module **30** therein. The pump housing **60** includes an exterior surface **62.** The sensor **50** is disposed on (or proximal to) the exterior surface **62** of the pump housing **60;** optionally, the sensor **50** is mounted external to the pump housing **60;** alternatively, optionally, the sensor **50** is mounted internally to the pump housing **60.** Furthermore, the exterior surface **62** of the pump housing **60** comprises (or is) a pump face. Moreover, the pump face (or the exterior surface **62**) defines a fluid inlet port **70** and a fluid outlet port **72.** The device **10** further includes a controller **80** that is operable, namely configured, to calculate the rotational position of the drive shaft **22** based upon the output signal, and control the motor **20** based upon the calculated rotational position to ensure that an accurate volume of fluid is pumped.

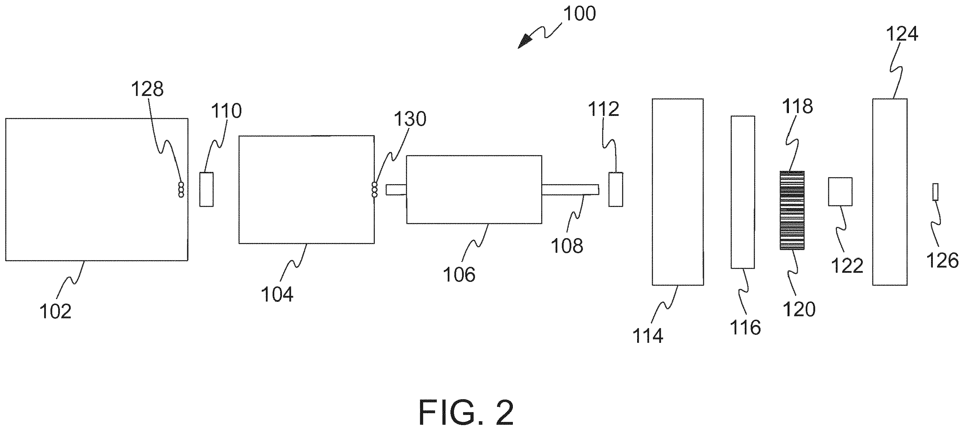

In FIG. 2, there is provided an exploded plan view of a gear pump **100**, in accordance with the present disclosure. It will be appreciated that, the gear pump **100** is a particular type of a device for pumping fluid, for example such as the device **10.** As shown, the gear pump **100** includes a motor having a motor casing **102,** a motor stator **104,** a motor rotor **106,** a drive shaft **108**, a rear bearing **110** and a front bearing **112.** The gear pump **100** also includes a pump head casing **114,** a pump cylinder **116,** a gear assembly having a drive gear **118** and an idler gear **120,** an annular magnet **122,** a pump face **124** and a sensor **126**. Further, the motor casing **102** includes holes **128** for allowing motor power wiring **130** to pass therethrough.

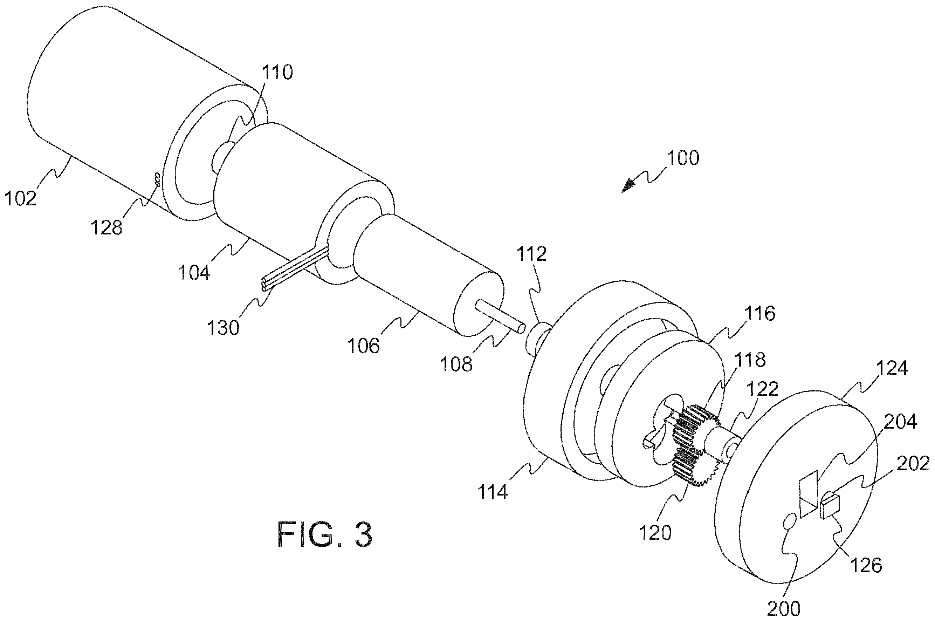

In FIG. 3, there is illustrated an exploded isometric view of the gear pump of FIG. 1 additionally including a fluid inlet port **200** and a fluid outlet port **202** configured or arranged on the pump face **124.** The pump face **124** also includes a trench **204.**

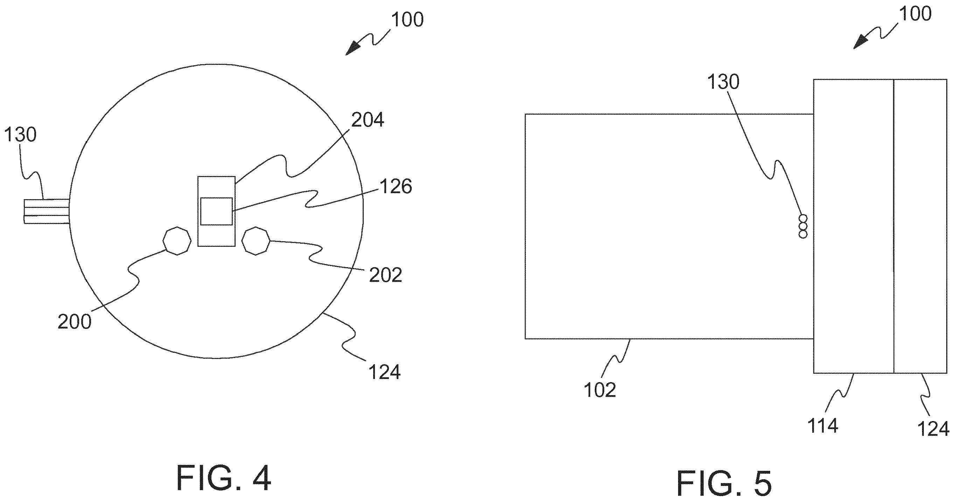

Referring next to FIG. 4, there us shown an illustration of an assembled front elevation view of the gear pump of FIG. 1. As shown, the pump face **124** constitutes an exterior surface of a pump housing (which is formed by the pump head casing **114** and the pump face **124,** shown in FIG. 2). The fluid inlet port **200** and the fluid outlet port **202** are shown with small circles on the pump face **124.** The trench **204** is shown with a rectangular box between the fluid inlet port **200** and the fluid outlet port **202.** The sensor **126** is disposed on the pump face **124,** namely on the exterior surface of the pump housing. Specifically, the sensor **126** is disposed within the trench **204.** Furthermore, the trench **204** is positioned in the pump face **124** such that the sensor **126** is disposed coaxially with the annular magnet **122** (shown in FIG. 2). In FIG. 3, there is also provided an illustration of the motor power wiring **130** extending through the motor casing **102** (shown in FIG. 2).

In FIG. 5, there is provided an illustration of an assembled plan view of the gear pump of FIG. 1. As shown, the motor casing **102** is coupled with the pump head casing **114.** Furthermore, the pump head casing **114** is shown coupled to the pump face **124** for configuring the pump housing, which houses the pump cylinder **116,** the drive gear **118,** the idler gear **120** and the annular magnet **122** (shown in FIG. 2). In FIG. 4, there is also provided an illustration of the motor power wiring **130** extending through the motor casing **102.**

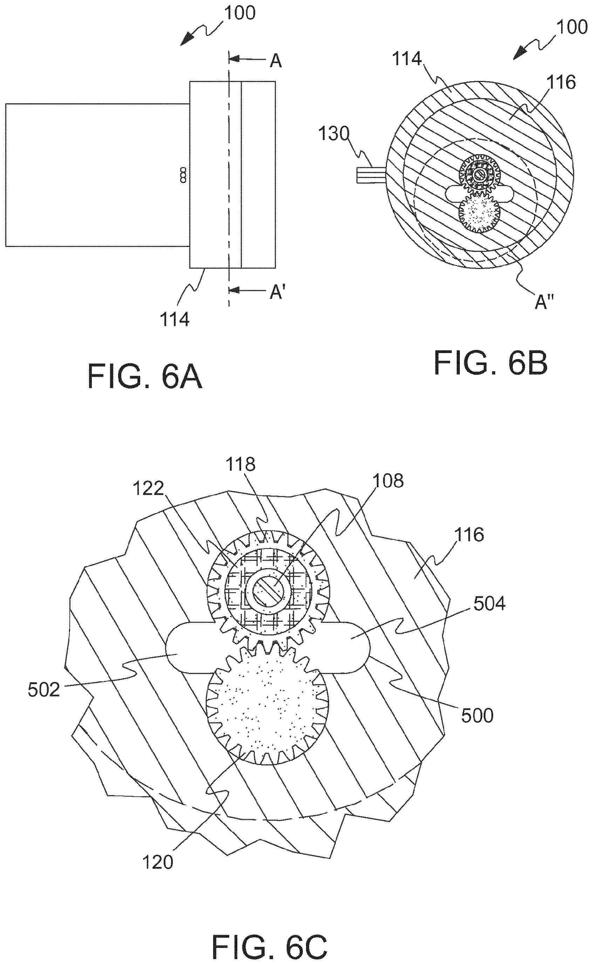

Referring next to FIGS. 6A-C, there are shown therein illustrations of the assembled plan view of the gear pump of FIG. 1, a cross-sectional view of the assembled plan view about an axis A-A', and an enlarged view of a portion A" of the cross-sectional view, respectively. In FIG. 6A, there explicitly shown the axis A-A', vertically positioned on the pump head casing **114,** along which the cross-sectional view of the gear pump **100** is shown (namely FIG. 6B).

In FIG. 6B, there is shown the pump head casing **114** and the pump cylinder **116** (using different hatch patterns), received into the pump head casing **114.** Moreover, in FIG. 6B, there is also illustrated the motor power wiring **130** arranged, namely configured, to extend through the motor casing **102** (shown in FIG. 2). Furthermore, in FIG. 6B, there is shown an illustration of the circular portion A" (shown with dotted line), enclosing various components of the gear pump **100** shown with enlarged view (namely FIG. 6C).

In FIG. 6C, there is provided an enlarged view of the components of the gear pump **100** enclosed by the circular portion A". As shown, the pump cylinder **116** includes a channel **500** that is arranged, namely configured, to receive the drive gear **118** and the idler gear **120.** The channel **500** mainly includes a circular through opening conforming to outer surfaces of the drive gear **118** and the idler gear **120** for being received therein. Furthermore, the drive gear **118** and the idler gear **120** are operable to be engaged (or meshed) with each other when received in the channel **500.** Moreover, the drive gear **118** is disposed coaxially on the drive shaft **108.** Specifically, the drive gear **118** encloses the annular magnet **122,** which is coupled to the drive shaft **108.** Therefore, the drive shaft **108** is arranged in operation, namely configured, to rotate the drive gear **118** and the annular magnet **122** mounted thereon. Furthermore, the drive gear 118 is supported within the channel **500** with the help of the drive shaft **108,** whereas the idler gear **120** is merely supported within the circular through opening of the channel **500.** The channel **500** also includes side opening **502, 504** on either sides of the channel **500.** The side openings **502, 504** of the channel **500** are in line with the fluid inlet port **200** and the fluid outlet port **202,** respectively, (shown in FIG. 2). A substrate or fluid enters into and leaves from the channel **500** through the side opening **502, 504,** respectively.

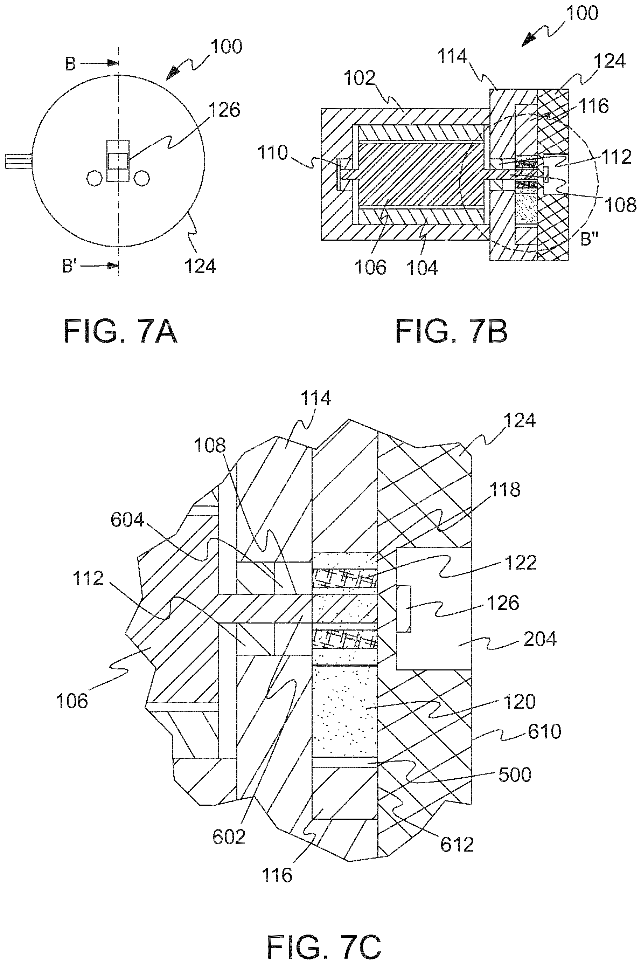

In FIGS. 7A-C, there are provided illustrations of the assembled elevation view of the gear pump of FIG. 1, a cross-sectional view of the assembled elevation view about an axis B-B', and an enlarged view of a portion B" of the cross-sectional view, respectively. In FIG. 7A, there is explicitly shown the axis B-B', vertically and centrally positioned on the pump face **124,** along which the cross-sectional view of the gear pump **100** is shown (namely FIG. 7B).

In FIG. 7B, there is shown the motor casing **102** coupled to the pump head casing **114** for enclosing the motor stator **104** and the motor rotor **106** therein. The pump head casing **114** is further coupled to the pump face **124** for enclosing the pump cylinder **116** along with other components, which will be explained in detail in conjunction with FIG. 7C. Moreover, in FIG. 7B, there is also illustrated the rear bearing **110,** wherein the front bearing **112** is coaxially attached onto end portions of the drive shaft **108,** particularly the rear bearing **110** is received in a cut-out provided on the motor casing **102** and the front bearing **112** is received in a through opening provided in the pump head casing **114.**

In FIG. 7C, there is shown an enlarged view of the components of the gear pump **100** enclosed by the circular portion B". As shown, an end portion **602** of the drive shaft **108** extends from the motor rotor **106.** Furthermore, the end portion **602** of the drive shaft **108** passes through the front bearing **112** (received in a through opening **604** provided in the pump head casing **114**). The end portion **602** of the drive shaft **108** is further coupled to the annular magnet **122,** which is surrounded by the drive gear **118.** The drive gear **118** is further shown engaged to the idler gear **120,** received within the channel **500** of the pump cylinder **116.** In FIG. 7C, there is also illustrated the trench **204** arranged, namely configured, on the pump face **124.** The trench **204** accommodates the sensor **126** therein. As shown, the trench **204** extends from an outer surface **610** to an inner surface **612** of the pump face **124** such that when the sensor **126** is positioned inside the trench **204,** the sensor **126** is positioned in proximity to the annular magnet **122.** This allows the sensor **126** to sense efficiently rotation of the annular magnet **122** and to generate an output signal corresponding to a rotational position of the drive shaft **108.**

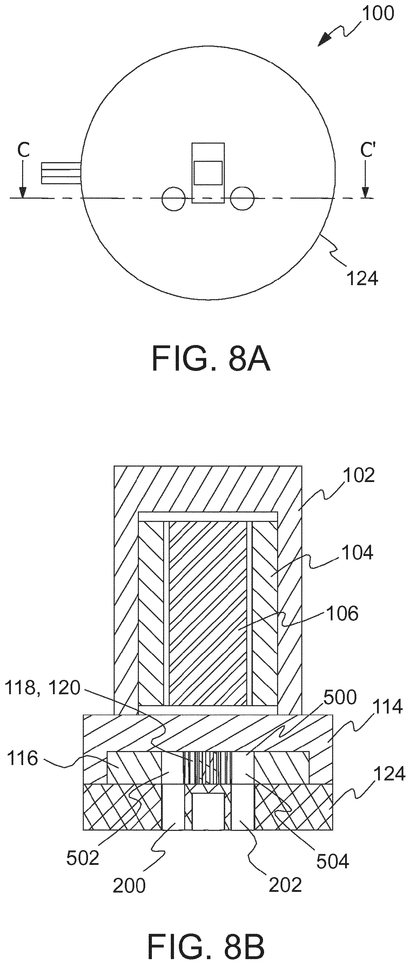

In FIGS. 8A-B*, there are provided illustrations of the assembled elevation view of the gear pump of FIG. 1 and a cross-sectional view of the assembled elevation view about an axis C-C, respectively. Moreover, in FIG. 8A, there is explicitly shown the axis C-C, horizontally and non-centrally positioned on the pump face **124,** along which the cross-sectional view of the gear pump **100** is shown (namely FIG. 8B).

In FIG. 8B, there is shown the motor casing **102** coupled to the pump head casing **114,** enclosing the motor stator **104** and the motor rotor **106.** The pump head casing **114** is further coupled to the pump face **124** for enclosing the pump cylinder **116** and the drive and idler gears **118, 120.** The drive and idler gears **118, 120** are received in the channel **500** of the pump cylinder **116.** FIG. 8B essentially shows a fluidic coupling between the channel **500** and the fluid inlet port **200** and the fluid outlet port **202** present in the pump face **124.** As shown, the side opening **502, 504** (present on either sides of the channel **500**) are in line with the fluid inlet port **200** and the fluid outlet port **202,** respectively. Therefore, the substrate enters into and leaves from the channel **500** through the fluid inlet port **200** and the fluid outlet port **202,** respectively.

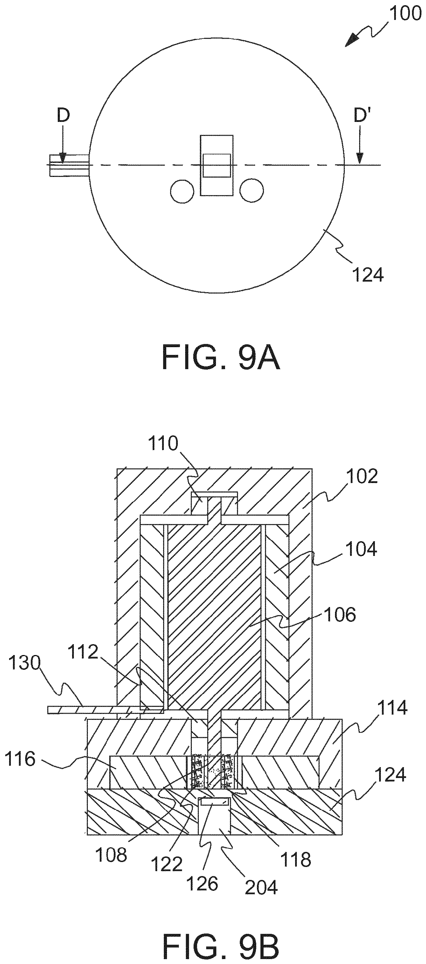

In FIGS. 9A-B, there are provided illustrations of the assembled elevation view of the gear pump of Fig. 1 and a cross-sectional view of the assembled elevation view about an axis D-D', respectively. FIG. 9A explicitly shows the axis D-D', horizontally and centrally positioned on the pump face **124,** along which the cross-sectional view of the gear pump **100** is shown (namely FIG. 9B).

In FIG. 9B, there is also shown the motor casing **102** coupled to the pump head casing **114,** and enclosing the motor stator **104** and the motor rotor **106** therein. The pump head casing **114** is further coupled to the pump face **124** for enclosing the pump cylinder **116** therein. Moreover, in FIG. 9B, there is also further illustrated the rear bearing **110** and the front bearing **112** coaxially attached to the end portions of the drive shaft **108.** Furthermore, in FIG. 9B, there is also illustrated the annular magnet **122** mounted on the end portion of the drive shaft **108,** and the annular magnet **122** is enclosed by the drive gear **118.** Yet additionally, in FIG. 9B, there is provided an illustration of the trench **204** accommodating the sensor **126,** and the motor power wiring **130** coupled the motor stator **104** and extending through the motor casing **102.**

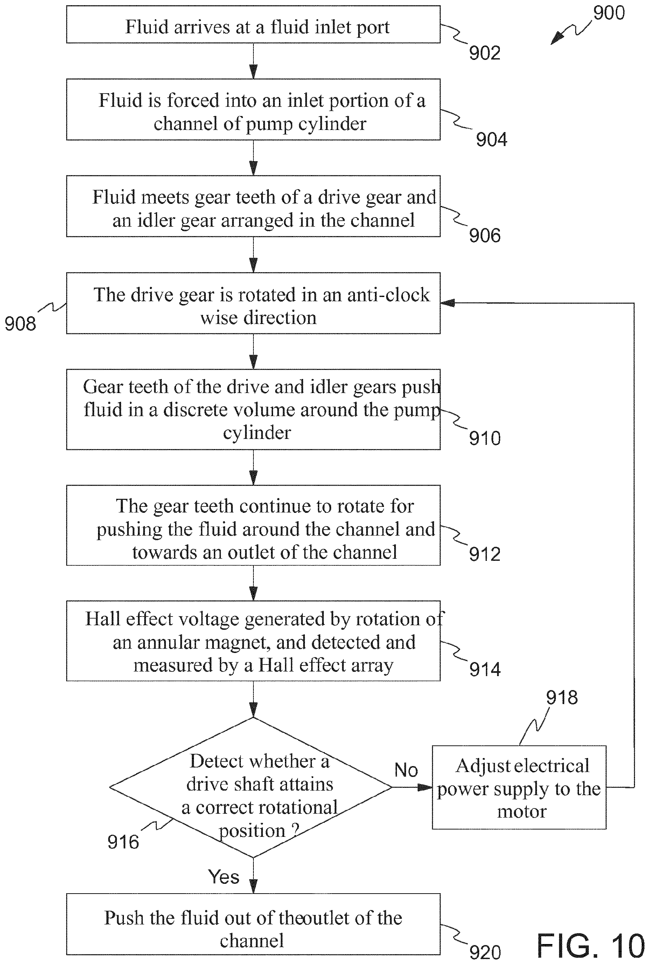

Referring now to FIG. 10, there is shown an illustration of a flow chart **900** depicting steps of a method of operating a gear pump, such as the gear pump **100,** for pumping fluid, in accordance with the present disclosure. Primarily, a method of operating the gear pump for pumping fluid includes following steps, namely:
(i) driving a motor of the pump for rotating a drive shaft to pull the fluid towards an inlet of a channel of a pump cylinder;
(ii) rotating a drive gear and an idler gear by the drive shaft to push the fluid from the inlet towards an outlet of the channel;
(iii) generating a Hall Effect voltage by a Hall Effect array in response to rotation of an annular magnet disposed coaxially with the drive shaft;
(iv) calculating a rotational position of the drive shaft by a controller based upon the Hall Effect voltage; and
(v) controlling the motor based upon the calculated rotational position to ensure that an accurate volume of the fluid is pumped out of the outlet of the channel. However, in the flow chart **900** of FIG. 10, there is depicted the operational steps of the gear pump in greater detail.

At a step **902,** the fluid or substrate arrives at the fluid inlet port 200 of the pump face **124** may be from a reservoir.

At a step **904,** the fluid is forced into an inlet portion (namely the side opening **502**) of the channel **500** of the pump cylinder **116** from the fluid inlet port **200.**

At a step **906,** the fluid meets the gear teeth of both the drive gear **118** and the idler gear **120,** arranged inside the channel **500** of the pump cylinder **116.**

At a step **908,** the drive gear **118** (mounted on the end portion, of the drive shaft **108,** which protrudes beyond the front bearing **112**) is rotated in an anti-clock wise direction. For example, an electrical power (of about 24 volts) is supplied to the motor, particularly to the motor stator **104** for generating a magnetic field, which influences the motor rotor **106** to attain a rotary motion and in-turn rotate the drive shaft **108.** The rotation of the drive gear **118** further rotates the idler gear **120** in a clockwise direction. Therefore, the fluid is forced into the side opening **502** of the channel **500** due to a suction pressure zone generated at the fluid inlet port **200** by the rotation of the drive and idler gears **118, 120** within the channel **500.**

At a step **910,** gear teeth of the drive and idler gears **118, 120** push fluid in a discrete volume around the pump cylinder. Specifically, the gear teeth of the drive and idler gears **118, 120** are enclosed by the channel **500** of the pump cylinder **116,** therefore, a discrete enclosed volume is formed by spaces between each of the gear teeth and the pump cylinder **116.** Furthermore, uniform construction of the drive and idler gears **118, 120,** and smoothness of the channel **500** ensure that each of these discrete enclosed volumes is exactly the same, and within a manufacturing tolerance. Therefore, each complete rotation of the drive and idler gears **118, 120** delivers exactly a same volume of the fluid, under constant pressure and consistent fluid characteristics. Accordingly, this uniform behaviour when allied with a precise rotational control of the drive shaft **108** allows the gear pump **100** to pump an accurate volume of the fluid.

At a step **912,** the gear teeth continue to rotate for pushing the fluid around the channel **500** and towards an outlet (namely the side opening **504**) of the channel **500.** Specifically, the fluid is forced into the side opening **504** of the channel **500** due to an ejection pressure zone generated at the fluid outlet port **202** by the rotation of the drive and idler gears **118, 120** within the channel **500.** Furthermore, as the drive and idler gears **118, 120** are rotated continuously by the drive shaft **108;** therefore each rotation pushes a same volume of the fluid around and towards the outlet of the channel **500.**

At a step **914,** there is detected the Hall Effect voltage generated by rotation of the annular magnet **122,** and detected and measured by the Hall Effect array comprised within sensor **126.** The Hall Effect voltage (or fluctuation) of the magnetic field is generated due to the rotation of the annular magnet **122,** which is rotated by the drive shaft **108.** Furthermore, the generated Hall Effect voltage is detected and measured by the Hall Effect array comprised within the sensor **126,** which is arranged on the trench **204** and positioned close to the annular magnet **122.**

At a step **916,** there is detected whether or not the drive shaft **108** attains a correct rotational position, as calculated by a controller based upon the Hall Effect voltage measured by the Hall Effect array. The controller is optionally a servo-controller, or separate from the servo-controller, such as a monolithic electronic unit having the Hall Effect array and a microcontroller. The controller identifies a relationship between the Hall Effect voltage, and the rotational position of the drive shaft **108.**

At a step **918,** there is adjusted an electrical power supply to the motor, if the drive shaft **108** does not attains the correct rotational position. Thereafter, the step **908** is followed to correct the rotational position of the drive shaft **108.** Specifically, the controller controls the electrical power supply to the motor based upon the calculated rotational position to ensure that an accurate volume of fluid is pumped. For example, the Hall Effect sensor array voltage signal is fed to the servo-controller, which compares the implied rotational position of the drive shaft **108** which is derived from the voltage signal, and alters the power delivered to the motor so as to attain the correct rotational position of the drive shaft **108** and to pump or dispense correct volume of the fluid.

At a step **920,** the fluid is pushed out of the outlet of the channel **500,** if the drive shaft **108** attains the correct rotational position. Specifically, the fluid is pushed towards the fluid outlet port **202** from the outlet of the channel **500** for dispensing the accurate volume of the fluid. Thereafter, again monitoring and correcting of the rotational position of the drive shaft **108** for subsequent operational cycle of the gear pump **100,** based on the steps **902** to **918** is much appreciated.

The present disclosure provides a gear pump that enables pumping of an accurate volume of the fluid by measuring and controlling the rotational position of the drive shaft. Furthermore, the design and manufacturing of the gear pump avoids the need for providing a mechanical sealing between the fluid and the sensor (or encoder), thereby reducing overall complexity and cost of manufacturing of the gear pump. Additionally, the disclosed gear pump enables isolation of the sensor from the fluid, thereby allowing it to function more efficiently and accurately.

The present disclosure provides a gear pump that enables pumping of an accurate volume of the fluid, for example a liquid, gas, foam, emulsion, suspension, gel or similar, by measuring and controlling the rotational position of the drive shaft. Furthermore, the design and manufacturing of the gear pump avoids a need for providing a mechanical sealing between the fluid and the sensor (or encoder), thereby reducing overall complexity and cost of manufacturing of the gear pump. Additionally, the disclosed gear pump enables isolation of the sensor from the fluid, thereby allowing it to function more efficiently and accurately. The gear pump of the present disclosure does not need to include mechanical seals, and therefore, potentially requires less maintenance. Consequently, Mean Time Between Failure (or MTBF) for the gear pump and automatic failure detection for all common failure modes is enhanced, namely higher. A lack of mechanical seals also improves efficiency of the gear pump due to elimination of friction losses. Furthermore, the gear pump has a simple design, increased potential for miniaturisability, and a good price-to-performance ratio. Moreover, the gear pump is capable of operating in harsh, hostile, or hazardous ambient conditions due to lack of environmentally exposed sensitive or moving parts. Additionally, failure of the gear pump is unlikely to result in leakage between the substrate and the environment, since failure-prone parts thereof are contained entirely in the statically sealed pump housing. Therefore, the gear pump described in the present disclosure has reduced substrate contamination from environment, even when operating under negative pressure (substrate to ambient) or vacuum. The gear pump also has reduced environmental contamination with substrate, even when operating under positive pressure (substrate to ambient). Furthermore, for low temperature processes, the substrate cools the pump motor. The gear pump is optionally implemented in a fully passive (semiconductor free) and fixed magnet free environment, for extreme high temperature tolerance or ionising radiation tolerance. Additionally, the gear pump of the present disclosure provides extra process control information without use of additional sensors. Moreover, deviations from normal values such as improper pump functionality, or substrate pressure across pump, are highlighted during use of the pump. For example, variations in torque to speed ratio or speed over a period of time is indicative of health of the pump (such as broken pump drive shaft, missing tooth on pump gear, worn pump gears, jammed pump head, worn pump cylinder, overpressure, blockage, and so forth) and process conditions (such as lumpy substrate, thin or thick substrate, gas in a liquid substrate, small hard particulates, and so forth).

It will be appreciated from the foregoing that the gear pump is conveniently controlled by monitoring an angular position of the drive shaft. However, after a prolonged period of operation, wear can occur in the gear pump that results in backlash. To address such backlash, it is beneficial that any idler gears of the gear pump are subjected to viscous drag forces, for example generated electromagnetically via eddy current induction, so that they always follow motion of drive gears. However, it will be appreciated that enhanced accuracy of the gear pump is achieved by measuring angular positions of its gear wheels rather than, or in addition to, the drive shaft. However, measuring the angular positions of the driven and idler gears is very difficult to achieve optically, especially when the substrate is optically opaque. For such reason, the gear pump beneficially employs the aforementioned magnetic sensors and/or the aforementioned electrostatic sensor (namely variable capacitance sensor) and/or the aforementioned magnetic inductive sensor because such sensors are less adversely influenced by optical properties of the substrate.

When both angular positions of the drive shaft and one or more of the drive and idler gears are sensed for controlling pumping of the gear pump when in operation, mutually different servo loops are employed, for example in a nested configuration, for the drive shaft and the gears. Thus, one of the servo loops is involved with correcting for backlash and flexure in the drive shaft, whereas another of the servo loops is involved with controlling a majority of rotation provided by the motor when in operation. The servo loop for coping with backlash is beneficially a PID control algorithm that is specifically adjusted for coping with transport delay that is equivalent, in effect, to backlash in its temporal characteristics.

### REFERENCE KEY FOR THE PARTS SHOWN IN THE DRAWINGS

The following list provides a key to the part numbers used in the figures and their foregoing description. The same part number may be referred to in different embodiments of the invention and will be prefaced by a number indicating the number of the embodiment.
- **10 -**: device
- **20 -**: motor
- **30 -**: pump module
- **40 -**: sensor target
- **50 -**: sensor
- **60 -**: pump housing
- **62 -**: exterior surface
- **70 -**: fluid inlet port
- **72 -**: fluid outlet port
- **80 -**: controller
- **100** -: gear pump
- **102** -: motor casing
- **104** -: motor stator
- **106** -: motor rotor
- **108** -: drive shaft
- **110 -**: rear bearing
- **112 -**: front bearing
- **114 -**: pump head casing
- **116** -: pump cylinder
- **118 -**: drive gear
- **120** -: idler gear
- **122** -: annular magnet
- **124 -**: pump face
- **126** -: sensor
- **128** -: holes on the motor casing
- **130** -: motor power wiring
- **200** -: fluid inlet port
- **202** -: fluid outlet port
- **204** -: trench
- **500** -: channel
- **502, 504** -: side openings of the channel
- **602** -: end portion of the drive shaft
- **604** -: through opening of the pump head casing
- **610** -: outer surface of the pump face
- **612** -: inner surface of the pump face

Modifications to embodiments of the present disclosure described in the foregoing are possible without departing from the scope of the present disclosure as defined by the accompanying claims. Expressions such as "including", "comprising", "incorporating", "have", "is" used to describe and claim the present disclosure are intended to be construed in a non-exclusive manner, namely allowing for items, components or elements not explicitly described also to be present. Reference to the singular is also to be construed to relate to the plural. Expression such as "one or more" and "at least one" are to be construed to relate to the singular in an example embodiment, and to relate to the plural in another example embodiment.

## Claims

1. A gear pump (100) for pumping fluid, wherein the gear pump (100) comprises:
- a motor for diving a rotatable drive shaft (108);
- a drive gear (118) that is operable to be driven by the drive shaft (108);
- an idler gear (120) which meshes with the drive gear (118);
- an annular magnet (122) disposed coaxially with the drive shaft (108) and operable to rotate therewith;
- a sensor (126) for sensing rotation of the annular magnet (122) and generating an output signal corresponding to a rotational position of the drive shaft (108); **characterized in that** the gear pump further comprises:
- a controller that is operable to calculate the rotation position of the drive shaft (108) based upon the output signal and to control the motor based upon the calculated rotational position to ensure that a controlled volume of fluid is pumped,
wherein the controller employs a PID control algorithm to cope with backlash, and
wherein, to avoid backlash, the idler gear (120) is provided with viscous drag so that the idler gear (120) always follows motion of the drive gear (118).

2. A gear pump (100) of claim 1, **characterized in that** the sensor (126) comprises a Hall Effect array that is operable to generate the output signal in a form of a Hall Effect voltage in response to the rotation of the annular magnet (122).

3. A gear pump (100) of claim 1 or 2, **characterized in that** the annular magnet (122) is disposed within the drive gear (118).

4. A gear pump (100) of any one of claims 1 to 3, **characterized in that** the annular magnet (122) is magnetised diametrically.

5. A gear pump (100) of any one of claims 1 to 4, **characterized in that** the gear pump (100) further comprises a pump housing having an exterior surface.

6. A gear pump (100) of claim 5, **characterized in that** the sensor (126) is disposed on or proximal to the exterior surface of the pump housing.

7. A gear pump (100) of claim 5, **characterized in that** the sensor (126) is disposed on or proximal to an inside region within the exterior surface of the pump housing.

8. A gear pump (100) of claim 6 or 7, **characterized in that** the exterior surface of the pump housing comprises a pump face (124).

9. A gear pump (100) of claim 8, **characterized in that** the pump face (124) comprises a trench (204) and wherein the sensor (126) is disposed at least partially within the trench (204).

10. A gear pump (100) of claim 9, **characterized in that** the trench (204) is position in the pump face (124) such that the sensor (126) is disposed coaxially with the annular magnet (122).

11. A gear pump (100) of claim 8, **characterized in that** the pump face (124) defines a fluid inlet port (200) and a fluid outlet port (202).

12. A gear pump (100) of any one of the preceding claims, **characterized in that** the controller includes a plurality of servo loops coupled to the sensor (126) for controlling the motor, wherein the plurality of servo loops are of mutually different response bandwidth and of mutually different gains.

13. A gear pump (100) of claim 12, **characterized in that** at least one of the servo loops is operable to monitor an angular position of the drive shaft (108), and at least one of the servo loops is operable to monitor an angular position of at least one of the drive gear (118) and the idler gear (120).

14. A gear pump (100) of any one of the preceding claims, **characterized in that** the controller is operable to employ a nested position feedback loop.

15. A method of pumping fluid using a gear pump (100), **characterized in that** the method comprises steps of:
- driving a motor to rotate a drive shaft (108), and arranging for the drive shaft (128) to rotate a drive gear (118) and thereby an idler gear (120) of a pump module for pumping fluid, and for rotating a sensor target (40, 122) associated with the drive shaft (108) and/or the drive gear (118) and/or the idler gear (120);
- using a sensor (126) to sense rotation of sensor target (40, 122) and to generate an output signal corresponding to an angular position of the sensor target (40, 122);
- calculating the rotation position of the drive shaft (108) and/or the drive gear (118) and/or the idler gear (120) based upon the output signal; and
- controlling the motor based upon the calculated rotational position to controllably pump a volume of fluid,
wherein the controller employs a PID control algorithm to cope with backlash, and
wherein, to avoid backlash, the idler gear (120) is provided with viscous drag so that the idler gear (120) always follows motion of the drive gear (118).

16. A method of claim 15, **characterized in that** the method includes arranging for the sensor target (40) to include an annular magnet (122).

## Patentansprüche

1. Zahnradpumpe (100) zum Pumpen von Fluid, wobei die Zahnradpumpe (100) Folgendes umfasst:
- einen Motor zum Tauchen einer drehbaren Antriebswelle (108);
- ein Antriebszahnrad (118), das betreibbar ist, um durch die Antriebswelle (108) angetrieben zu werden;
- ein Laufrad (120), das mit dem Antriebszahnrad (118) in Eingriff steht;
- einen Ringmagneten (122), der koaxial mit der Antriebswelle (108) angeordnet ist und betreibbar ist, um sich damit zu drehen;
- einen Sensor (126) zum Erfassen einer Drehung des Ringmagneten (122) und zum Erzeugen eines Ausgangssignals, das einer Drehposition der Antriebswelle (108) entspricht; **dadurch gekennzeichnet, dass** die Zahnradpumpe ferner umfasst:
- eine Steuerung, die betreibbar ist, um die Drehposition der Antriebswelle (108) basierend auf dem Ausgangssignal zu berechnen und den Motor basierend auf der berechneten Drehposition zu steuern, um sicherzustellen, dass ein gesteuertes Volumen an Fluid gepumpt wird,
wobei die Steuerung einen PID-Steueralgorithmus verwendet, um Spiel zu bewältigen, und
wobei das Laufrad (120) mit einer viskosen Reibung bereitgestellt ist, so dass das Laufrad (120) immer der Bewegung des Antriebszahnrads (118) folgt, um Spiel zu vermeiden.

2. Zahnradpumpe (100) nach Anspruch 1, **dadurch gekennzeichnet, dass** der Sensor (126) ein Hall-Effekt-Array umfasst, das betreibbar ist, um das Ausgangssignal in Form einer Hall-Effekt-Spannung als Reaktion auf die Drehung des Ringmagneten (122) zu erzeugen.

3. Zahnradpumpe (100) nach Anspruch 1 oder 2, **dadurch gekennzeichnet, dass** der Ringmagnet (122) innerhalb des Antriebszahnrads (118) angeordnet ist.

4. Zahnradpumpe (100) nach einem der Ansprüche 1 bis 3, **dadurch gekennzeichnet, dass** der Ringmagnet (122) diametral magnetisiert ist.

5. Zahnradpumpe (100) nach einem der Ansprüche 1 bis 4, **dadurch gekennzeichnet, dass** die Zahnradpumpe (100) ferner ein Pumpengehäuse mit einer Außenfläche aufweist.

6. Zahnradpumpe (100) nach Anspruch 5, **dadurch gekennzeichnet, dass** der Sensor (126) an oder nahe der Außenfläche des Pumpengehäuses angeordnet ist.

7. Zahnradpumpe (100) nach Anspruch 5, **dadurch gekennzeichnet, dass** der Sensor (126) an oder nahe eines Innenbereichs innerhalb der Außenfläche des Pumpengehäuses angeordnet ist.

8. Zahnradpumpe (100) nach Anspruch 6 oder 7, **dadurch gekennzeichnet, dass** die Außenfläche des Pumpengehäuses eine Pumpenfläche (124) umfasst.

9. Zahnradpumpe (100) nach Anspruch 8, **dadurch gekennzeichnet, dass** die Pumpenfläche (124) einen Graben (204) umfasst und wobei der Sensor (126) mindestens teilweise innerhalb des Grabens (204) angeordnet ist.

10. Zahnradpumpe (100) nach Anspruch 9, **dadurch gekennzeichnet, dass** der Graben (204) in der Pumpenfläche (124) positioniert ist, so dass der Sensor (126) koaxial mit dem Ringmagneten (122) angeordnet ist.

11. Zahnradpumpe (100) nach Anspruch 8, **dadurch gekennzeichnet, dass** die Pumpenfläche (124) eine Fluideinlassöffnung (200) und eine Fluidauslassöffnung (202) definiert.

12. Zahnradpumpe (100) nach einem der vorstehenden Ansprüche, **dadurch gekennzeichnet, dass** die Steuerung eine Vielzahl von Regelschleifen einschließt, die mit dem Sensor (126) zum Steuern des Motors gekoppelt sind, wobei die Vielzahl von Regelschleifen von untereinander unterschiedlicher Antwortbandbreite und von untereinander unterschiedlichen Verstärkungen sind.

13. Zahnradpumpe (100) nach Anspruch 12, **dadurch gekennzeichnet, dass** mindestens eine der Regelschleifen betreibbar ist, um eine Winkelposition der Antriebswelle (108) zu überwachen, und mindestens eine der Regelschleifen betreibbar ist, um eine Winkelposition von mindestens einem des Antriebszahnrads (118) und des Zwischenzahnrads (120) zu überwachen.

14. Zahnradpumpe (100) nach einem der vorstehenden Ansprüche, **dadurch gekennzeichnet, dass** die Steuerung betreibbar ist, um eine Rückkopplungsschleife einer verschachtelten Position zu verwenden.

15. Verfahren zum Pumpen von Fluid unter Verwendung einer Zahnradpumpe (100), **dadurch gekennzeichnet, dass** das Verfahren die folgenden Schritte umfasst:
- Antreiben eines Motors, um eine Antriebswelle (108) zu drehen, und Anordnen der Antriebswelle (128), um ein Antriebszahnrad (118) und dadurch ein Laufrad (120) eines Pumpenmoduls zum Pumpen von Fluid und zum Drehen eines Sensorziels (40, 122), das mit der Antriebswelle (108) und/oder dem Antriebszahnrad (118) und/oder dem Laufrad (120) verbunden ist, zu drehen;
- Verwenden eines Sensors (126), um eine Drehung des Sensorziels (40, 122) zu erfassen und ein Ausgangssignal zu erzeugen, das einer Winkelposition des Sensorziels (40, 122) entspricht;
- Berechnung der Drehposition der Antriebswelle (108) und/oder des Antriebszahnrads (118) und/oder des Laufrads (120) basierend auf dem Ausgangssignal und
- Steuern des Motors basierend auf der berechneten Drehposition, um ein Fluidvolumen steuerbar zu pumpen,
wobei die Steuerung einen PID-Steueralgorithmus verwendet, um Spiel zu bewältigen, und
wobei das Laufrad (120) mit einer viskosen Reibung bereitgestellt ist, so dass das Laufrad (120) immer der Bewegung des Antriebszahnrads (118) folgt, um Spiel zu vermeiden.

16. Verfahren nach Anspruch 15, **dadurch gekennzeichnet, dass** das Verfahren Anordnen des Sensorziels (40) einschließt, um einen Ringmagneten (122) einzuschließen.

## Revendications

1. Pompe à engrenages (100) pour pomper du fluide, dans laquelle la pompe à engrenages (100) comprend :
- un moteur pour entraîner un arbre d'entraînement rotatif (108) ;
- un engrenage d'entraînement (118) qui peut être actionné pour être entraîné par l'arbre d'entraînement (108) ;
- un engrenage intermédiaire (120) qui s'engrène avec l'engrenage d'entraînement (118) ;
- un aimant annulaire (122) disposé de manière coaxiale avec l'arbre d'entraînement (108) et pouvant être actionné pour tourner avec celui-ci ;
- un capteur (126) pour détecter une rotation de l'aimant annulaire (122) et générer un signal de sortie correspondant à une position de rotation de l'arbre d'entraînement (108) ; **caractérisée en ce que** la pompe à engrenages comprend en outre :
- un contrôleur qui peut être actionné pour calculer la position de rotation de l'arbre d'entraînement (108) en fonction du signal de sortie et pour contrôler le moteur en fonction de la position de rotation calculée pour s'assurer qu'un volume contrôlé de fluide est pompé,
dans laquelle le contrôleur utilise un algorithme de contrôle PID pour surmonter le jeu, et
dans laquelle, pour éviter le jeu, l'engrenage intermédiaire (120) est pourvu d'une traînée visqueuse de sorte que l'engrenage intermédiaire (120) suit toujours le mouvement de l'engrenage d'entraînement (118).

2. Pompe à engrenages (100) selon la revendication 1, **caractérisée en ce que** le capteur (126) comprend un réseau à effet Hall qui peut être actionné pour générer le signal de sortie sous la forme d'une tension à Effet Hall en réponse à la rotation de l'aimant annulaire (122).

3. Pompe à engrenages (100) selon la revendication 1 ou 2, **caractérisée en ce que** l'aimant annulaire (122) est disposé à l'intérieur de l'engrenage d'entraînement (118).

4. Pompe à engrenages (100) selon l'une quelconque des revendications 1 à 3, **caractérisée en ce que** l'aimant annulaire (122) est magnétisé diamétralement.

5. Pompe à engrenages (100) selon l'une quelconque des revendications 1 à 4, **caractérisée en ce que** la pompe à engrenages (100) comprend en outre un boîtier de pompe ayant une surface extérieure.

6. Pompe à engrenages (100) selon la revendication 5, **caractérisée en ce que** le capteur (126) est disposé sur ou à proximité de la surface extérieure du boîtier de pompe.

7. Pompe à engrenages (100) selon la revendication 5, **caractérisée en ce que** le capteur (126) est disposé sur ou à proximité d'une région interne à l'intérieur de la surface extérieure du boîtier de pompe.

8. Pompe à engrenages (100) selon la revendication 6 ou 7, **caractérisée en ce que** la surface extérieure du boîtier de pompe comprend une face de pompe (124).

9. Pompe à engrenages (100) selon la revendication 8, **caractérisée en ce que** la face de pompe (124) comprend une tranchée (204) et dans laquelle le capteur (126) est disposé au moins partiellement à l'intérieur de la tranchée (204).

10. Pompe à engrenages (100) selon la revendication 9, **caractérisée en ce que** la tranchée (204) est position dans la face de pompe (124) de telle sorte que le capteur (126) est disposé de manière coaxiale avec l'aimant annulaire (122).

11. Pompe à engrenages (100) selon la revendication 8, **caractérisée en ce que** la face de pompe (124) définit un orifice d'entrée de fluide (200) et un orifice de sortie de fluide (202).

12. Pompe à engrenages (100) selon l'une quelconque des revendications précédentes, **caractérisée en ce que** le contrôleur inclut une pluralité de boucles d'asservissement couplées au capteur (126) pour contrôler le moteur, dans laquelle la pluralité de boucles d'asservissement sont de largeur de bande de réponse mutuellement différente et de gains mutuellement différents.

13. Pompe à engrenages (100) selon la revendication 12, **caractérisée en ce qu'**au moins l'une des boucles d'asservissement peut être actionnée pour surveiller une position angulaire de l'arbre d'entraînement (108), et au moins l'une des boucles d'asservissement peut être actionnée pour surveiller une position angulaire d'au moins l'un de l'engrenage d'entraînement (118) et de l'engrenage intermédiaire (120).

14. Pompe à engrenages (100) selon l'une quelconque des revendications précédentes, **caractérisée en ce que** le contrôleur peut être actionné pour employer une boucle de rétroaction de position imbriquée.

15. Procédé de pompage de fluide utilisant une pompe à engrenages (100), **caractérisé en ce que** le procédé comprend les étapes consistant à :
- entraîner un moteur pour faire tourner un arbre d'entraînement (108), et agencer l'arbre d'entraînement (128) pour faire tourner un engrenage d'entraînement (118) et de ce fait un engrenage intermédiaire (120) d'un module de pompe pour pomper du fluide, et pour faire tourner une cible de capteur (40, 122) associée à l'arbre d'entraînement (108) et/ou à l'engrenage d'entraînement (118) et/ou à l'engrenage intermédiaire (120) ;
- utiliser un capteur (126) pour détecter une rotation de cible de capteur (40, 122) et pour générer un signal de sortie correspondant à une position angulaire de la cible de capteur (40, 122) ;
- calculer la position de rotation de l'arbre d'entraînement (108) et/ou de l'engrenage d'entraînement (118) et/ou de l'engrenage intermédiaire (120) en fonction du signal de sortie ; et
- contrôler le moteur en fonction de la position de rotation calculée pour pomper de façon contrôlable un volume de fluide,
dans laquelle le contrôleur utilise un algorithme de contrôle PID pour surmonter le jeu, et
dans laquelle, pour éviter le jeu, l'engrenage intermédiaire (120) est pourvu d'une traînée visqueuse de sorte que l'engrenage intermédiaire (120) suit toujours le mouvement de l'engrenage d'entraînement (118).

16. Procédé selon la revendication 15, **caractérisé en ce que** le procédé inclut un agencement pour que la cible de capteur (40) inclue un aimant annulaire (122).
